# EUROPEAN PATENT APPLICATION

(11) **EP 4 579 274 A1**
(43) Date of publication of application: **02.07.2025**
(21) Application number: 23857764.7
(22) Date of filing: 24.08.2023
(51) Int. Cl.: G01S 7/481, H05K 7/20, G05D 1/20

(54) **SENSOR DEVICE, LIDAR DEVICE, AND VEHICLE**

(30) Priority: 24.08.2022 US 202263400469 P; 23.05.2023 US 202318322314
(71) Applicant: LG INNOTEK CO. LTD, Gangseo-gu Seoul 07796 (KR)
(72) Inventor: GARDINEER, Bayard G., Pittsburgh, Pennsylvania 15222 (US)
(74) Representative: Plasseraud IP
(86) International application number: PCT/KR2023/012600
(87) International publication number: WO 2024/043732

(57) **Abstract**

A lidar device disclosed in embodiments may comprise: a main frame within which an accommodation part is provided; a transceiver assembly which is disposed in the accommodation part and has a circuit board, a light source array, and a sensor array; a bottom frame which is disposed under the main frame; and a plurality of heat dissipation members which are disposed at the respective side surfaces of the main frame, the plurality of heat dissipation members comprising a plurality of vertically arranged heat dissipation fins and a plurality of curved air guides.

## Description

### FIELD OF THE INVENTION

The present invention relates to a sensor device and a LiDAR device. More particularly, the present invention relates to a vehicle including a rotatable sensor device and a LiDAR device.

### BACKGROUND OF THE INVENTION

Autonomous vehicles (AVs) use a plurality of sensors for situational awareness. Sensors that are part of an autonomous vehicle's self-driving system (SDS) may include one or more of cameras, LiDAR (Light Detection and Ranging) devices, and inertial measurement units (IMUs). Sensors, such as cameras, and LiDAR are used to capture and analyze scenes around a vehicle. Thereafter, the captured scenes are used to detect objects, including static objects like fixed structures and dynamic objects such as pedestrians and other vehicles. Additionally, data collected from sensors may be used to detect conditions such as road markings, lane curvature, traffic lights, and signs. Furthermore, a scene representation, such as a three-dimensional point cloud obtained from a vehicle's LiDAR, may be combined with one or more images captured by cameras to obtain further insights into scenes or situations around the vehicle.

Additionally, a LiDAR transceiver may include a transmitter for emitting light within ultraviolet (UV), visible, or infrared spectrum range, or one or more photodetectors that convert other electromagnetic radiation into electrical signals. When sensing technologies such as LiDARs, cameras, ultrasonics, and radars are integrated into vehicles or other industrial platforms, environmental conditions affect sensing performance, such as heat, debris, or condensation. A network of pressurized air or liquid cooling systems may be used to mitigate negative effects of environmental conditions. However, these solutions are complex and require additional engineering to properly route cooling pipes through the platform without losing sensor performance.

### DETAILED DESCRIPTION OF THE INVENTION

### PROBLEM TO BE SOLVED

The present invention provides a sensor device, a LiDAR device, and an operation method thereof, each including heat dissipation elements.

The present invention also provides sensor devices and LiDAR devices equipped with heat dissipation members on one side, both sides, or all sides of a main frame that contains transceivers and heat-generating components.

The present invention also provides sensor devices and LiDAR devices having air guides that directs incoming airflow to windows on one or both sides of a housing.

The present invention also provides sensor devices and LiDAR devices including a plurality of transceivers. Additionally, the present invention provides a plurality of transceivers configured to emit and sense laser beams in different directions. Furthermore, the present invention provides a plurality of transceivers configured to emit and sense laser beams in different directions with different divergence angles. Accordingly, the present invention provides a device including a plurality of transceivers, in which performance specifications and operational purposes of the transceivers differ from one another.

The present invention also provides sensor devices and LiDAR devices capable of reducing weight, aerodynamic drag, and/or wind noise caused by high-speed rotation by including a pair of transceivers that face opposite directions to deliver a compact rotating assembly.

The present invention also provides sensor devices and LiDAR devices in which the center of mass of each transceiver is disposed directly opposite to each other with respect to the rotational center, thereby improving the inertial mass effect of optical sensors during rotation.

The present invention also provides sensor devices and LiDAR devices with a rigid structure that enables modular attachment of components such as cooling elements, window elements, and cleaning elements, has a housing space, and provides sufficient sealing from external and weather elements.

The present invention also provides heat dissipation members on both sides or around transceivers, which may absorb and release heat generated by the transceivers.

The present invention also provides sensor devices and LiDAR devices capable of preventing optical interference or crosstalk between two or more transceivers. The present invention also includes improvements in the inertial mass effects in rotating LiDAR devices. Namely, the center of mass of each transceiver may be disposed on opposite sides relative to the rotational center, minimizing movement during rotation by each transceiver.

The present invention also provides a mounting device for sensor devices and LiDAR devices, including a plurality of accommodation parts, for example, six fascia. Each accommodation part includes structural features to receive one or more components of a sensor assembly. For instance, one or more of six accommodation parts may accommodate modular cooling elements. Similarly, one or more of six accommodation parts is configured to receive modular detachable optical windows. One or more of six accommodation parts may protect transceiver assemblies securely. Accordingly, the mounting device may accommodate a plurality of different types of components, and provide a robust mounting structure.

The present invention also provides a mounting device for transceivers that offers a rigid structure, enables modular attachment of components such as cooling elements, window elements, and cleaning elements, provides space for accommodating elements, and provides sufficient sealing against external and weather elements.

The present invention also provides a LiDAR sensor system including a housing configured to secure the above components in place and accommodate electromagnetic devices, optical elements, cooling components, and architectural or structural elements. Enclosures are provided to deliver both functional and aesthetic solutions for the LiDAR sensor system, and may be designed to maximize the inflow and outflow of air for cooling and cleaning purposes. Furthermore, enclosures may provide an aerodynamic housing for the LiDAR sensor system.

### SOLUTION TO THE PROBLEM

An embodiment of the present invention provides a LiDAR device including: a main frame having a accommodation part inside; a transceiver assembly disposed in the accommodation part and having a circuit board, a light source array, and a sensor array; a bottom frame disposed below the main frame; and a plurality of heat dissipation members disposed on side surfaces of the main frame, respectively, in which the plurality of heat dissipation members includes a plurality of vertically arranged heat dissipation fins and a plurality of curved air guides.

In an embodiment, the bottom frame may have heat dissipation holes that face lower portions of the plurality of heat dissipation members, respectively.

In an embodiment, the LiDAR device may further include a heat dissipation cover disposed at the outside of the plurality of heat dissipation members.

In an embodiment, the heat dissipation cover may include grooves at a lower portion thereof, which are connected to the heat dissipation holes of the bottom frame.

In an embodiment, the LiDAR device may further include a plurality of frames coupled to the sides surfaces of the main frame, respectively, and having the heat dissipation members, in which at least one of the plurality of frames may include a window through which a laser beam is transmitted and received via the light source array and the sensor array, and one of the plurality of heat dissipation members may be disposed on one side of the window.

In an embodiment, the transceivers may include: a first transceiver configured to emit and sense laser beams in a first direction; and a second transceiver configured to emit and sense laser beams in an opposite direction to the first direction, the LiDAR device may further include an upper cover or a cover frame disposed on the first and second transceivers and coupled to an upper inner perimeter of the main frame, and the bottom frame may be coupled to a lower inner perimeter of the main frame.

In an embodiment, the LiDAR device may further include a first window disposed at a beam incidence side of the first transceiver and a second window disposed at a beam incidence side of the second transceiver may be included, wherein the first and second windows may be disposed outward with respect to the main frame.

In an embodiment, the first transceiver may include a first receiving optical system and a first sensor array, the second transceiver may include a second receiving optical system and a second sensor array, and the LiDAR device may further include a first lens tube disposed between the first receiving optical system and the first window, and a second lens tube disposed between the second receiving optical system and the second window may be included.

In an embodiment, the LiDAR device may further include a housing that covers upper portion and outer side of the main frame, in which the housing may have window holes through which laser beams are transmitted and received.

In an embodiment, the LiDAR device may further include a fixed frame that is secured to a movable body and has a stator; and a rotating frame that has a rotor facing the stator and is configured to rotate axially on the fixed frame, in which the rotating frame may rotate together with the main frame, the bottom frame, and the transceivers.

In an embodiment, the plurality of heat dissipation fins and the plurality of air guides may have flow paths for inflow and outflow of external air.

An additional scope of applicability of the present invention will become apparent from the following detailed description. However, the detailed description and specific examples, while illustrating preferred embodiments of the present invention, are provided merely as examples, as various changes and modifications within the spirit and scope of the invention will be apparent to those skilled in the art from this detailed description. The present invention will be more fully understood from the detailed description and the accompanying drawings provided below, which are given solely as examples and therefore do not limit the present invention.

### ADVANTAGES OF THE INVENTION

The embodiment of the present invention may enable and support modular attachment of components such as coupled cooling elements, window elements, and cleaning elements, while providing sufficient protection and sealing effects against external shocks and weather elements. The present invention may also accommodate and support components, thereby facilitating protection and coupling of the components. Additionally, the present invention may provide a device that allows components to be attached and detached.

According to an embodiment of the present invention, by including a pair of transceivers each arranged in different or opposing directions, the device may be miniaturized, and weight, aerodynamic drag, and/or wind noise caused by high-speed movement may be reduced. The present invention may also improve a packaging efficiency of the sensor head assembly. Moreover, the present invention may prevent optical interference caused by different transceivers.

According to the present invention, by positioning heat dissipation members on two or more sides, heat dissipation efficiency may be improved. Additionally, according to the present invention, by positioning air guides on one or both internal sides of the housing, airflows generated externally or internally may be guided from the window side to the bottom or from the bottom to the window. Accordingly, it may improve the heat dissipation effect of the window and internal heat-generating components.

The embodiment of the present invention allows optical impressions to be acquired at different divergence angles from different directions through a rotating imaging device such as a sensor devices or a LiDAR device, thereby improving sensing efficiency for the surrounding area.

### BRIEF DESCRIPTION OF DRAWINGS

FIG. 1 is a perspective view of a vehicle including a LiDAR device according to an embodiment of the present invention.
FIG. 2 is a block diagram representing an example of a vehicle system including the LiDAR device of FIG. 1.
FIG. 3 is a block diagram representing a transceiver of the LiDAR device of FIG. 2.
FIG. 4 is a perspective view of the LiDAR device according to an embodiment of the present invention.
FIG. 5 is an example perspective view of the LiDAR device of FIG. 4.
FIG. 6 is a perspective view of the housing of the LiDAR device of FIG. 4.
FIG. 7 is a plan view illustrating internal configurations of the LiDAR device of FIG. 4.
FIG. 8 is an exploded perspective view of internal and external configurations of the frames in the LiDAR device of FIG. 4.
FIG. 9 is an assembled plan view of FIG. 8.
   (a) and (a) of FIG. 10 are side cross-sectional views illustrating first and second transceivers coupled within the main frame in the LiDAR device according to the present invention.
FIG. 11 is a partial cross-sectional view of the first and second transceivers in the LiDAR device according to the present invention.
FIG. 12 is a perspective view illustrating an example of the combination of the first frame, the first transceiver, and the heat dissipation members of FIG. 8.
FIG. 13 is a perspective view illustrating an example of the combination of the second frame and the second transceiver of FIG. 8.
FIG. 14 is an exploded perspective view of the LiDAR device according to an embodiment of the present invention.
FIG. 15 is a view illustrating a modification example of the main frame and the heat dissipation covers in the LiDAR device according to an embodiment of the present invention.
FIG. 16 is a view for explaining beam paths and centers of the transceivers in FIG. 15.
FIG. 17 is a view for explaining beam paths of the transceiver in FIG. 15.
FIG. 18 is a view illustrating windows and heat dissipation covers in another embodiment of the present invention.
FIG. 19 is a perspective view illustrating disassembled heat dissipation covers, and frames of both sides of the rotating head in another embodiment of the present invention.
FIG. 20 is a rear perspective view of FIG. 19.
   (a) and (b) of FIG. 21 are views illustrating the air guides and heat dissipation covers of the side frames, to which each window of FIG. 19 is coupled.
FIG. 22 is a partial cross-sectional view illustrating a housing, heat dissipation covers, and air guides in another embodiment of the present invention.
FIG. 23 is, as a rear view of FIG. 22, a perspective view illustrating the bottom frame with heat dissipation holes.
FIG. 24 is a partial perspective view with the bottom frame with heat dissipation holes and the housing of the present invention.
   (a) and (b) of FIG. 25 are views for explaining the first and second heat dissipation members.
   (a) and (b) of FIG. 26 are perspective views illustrating examples of the combination of the side frames and the corner portions of the windows.
FIG. 27 is a view illustrating the heat distribution of the components on the main frame of the LiDAR device according to another embodiment of the present invention.
FIG. 28 is a view illustrating the internal heat-generating components and heat distribution of the main frame of the LiDAR device according to another embodiment of the present invention.
FIG. 29 is a view illustrating airflows of the air guide according to another embodiment of the present invention.
FIG. 30 is a view illustrating the distribution of airflows of the air guide in the LiDAR device according to another embodiment of the present invention.
FIG. 31 is a view illustrating the heat flow distribution by the heat dissipation members in the LiDAR device according to another embodiment of the present invention.

### BEST MODE FOR CARRYING OUT THE INVENTION

Below, embodiments will be described in detail with reference to the accompanying drawings, in which similar reference numerals denote similar components. However, the present invention is not limited to the embodiments illustrated in this specification, as it may be implemented in various forms. Rather, these embodiments are provided to ensure that the disclosure is thorough and complete by way of example and will fully convey the characteristics and features of the present invention to those skilled in the art. Accordingly, processes, components, and techniques that are not necessary for a complete understanding of the features and functionalities of the present invention by those skilled in the art of the present invention may not be described. Unless otherwise noted, similar reference numerals in the accompanying drawings and written descriptions denote similar components, and thus their descriptions will not be repeated.

A LiDAR system may also be referred to as a depth detection system, laser ranging system, laser radar system, LIDAR system, or laser/light detection and ranging (LADAR) system. LiDAR is a type of distance measuring sensor characterized by a long detection range, high resolution, and low interference by environment. LiDAR has been widely applied in fields such as intelligent robotics, unmanned aerial vehicles, autonomous driving, or self-driving. The operating principle of LiDAR is to estimate distances based on the round-trip time of electromagnetic waves (e.g., flight time or delay time) between the source and the target.

Typically, LiDAR systems, such as Direct Time-of-Flight (D-TOF) LiDAR systems, measure the distance (e.g., depth) to an object by emitting light pulses (e.g., laser pulses) toward the object and measuring the time it takes for the light pulses to reflect off the object and be detected by the LiDAR system's sensor. For instance, to reduce noise from ambient light, repeated measurements may be performed to generate individual histograms of relative time-of-flights (TOFs) based on the repeated measurements, and the peak of the individual histograms may be calculated to detect events (e.g., to detect the depth of regions or points of an object that reflects the light pulse back).

The above-described aspects and features of embodiments of the present invention will be described in more detail with reference to the drawings.

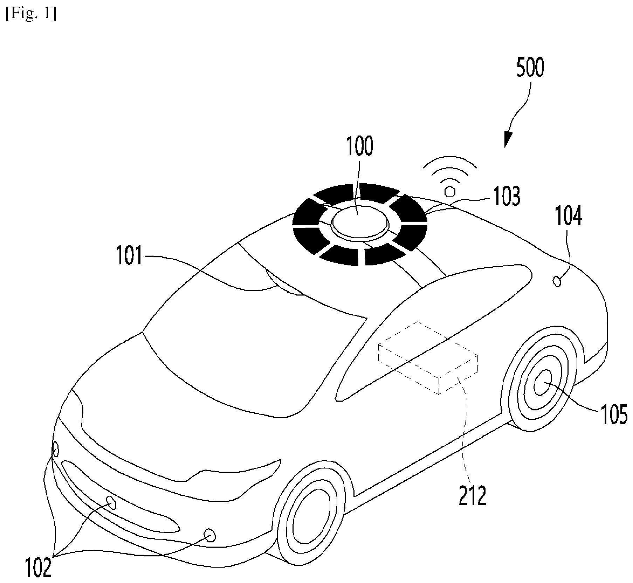

FIG. 1 is a perspective view of a vehicle including a LiDAR device according to an embodiment of the present invention.

Referring to FIG. 1, a movable body such as a vehicle 500 may include a LiDAR device 100, a camera unit 101, vehicle recognition sensors 102, 104, a global positioning system (GPS) sensor 103, a vehicle control module 212, and an ultrasonic sensor 105.

The LiDAR device 100, as a rotating imaging device or sensor device, is coupled to a part of the vehicle 500, rotates 360 degrees, senses distances between the vehicle and objects (static or dynamic objects), and surrounding environments and shapes, and controls driving operations using measured data. Three-dimensional point clouds using such sensing technologies may be used to collect and analyze surrounding objects or environments of the vehicle, and detection data may be generated to provide information about objects disposed within an appropriate proximity range.

The LiDAR device 100 may communicate with the vehicle control module 212, while transmitting and receiving information in accordance with the driving of the vehicle. The vehicle control module 212 communicates with various systems or sensors inside the vehicle and performs various controls. The vehicle control module 212, as a device that controls and monitors the vehicle's various systems, may include control devices such as an electronic control unit (ECU). The vehicle control module 212 may communicate with external mobile devices and may be electrically connected to detachable storage devices.

The camera unit 101 may be mounted in singularly or in plurality on the interior and/or exterior of the vehicle and may record images of the front and/or rear of the moving vehicle. Also, the recorded images may be provided through a display device (not shown) or stored. The recorded images data may optionally include audio data. In another example, the camera unit 101 may be mounted at the front, rear, corners, or sides of the vehicle 500 while recording surroundings of the vehicle and providing the recorded images through a display device (not shown). The vehicle control module 212 or another processor may identify traffic signals, vehicles, pedestrians, etc., based on the data recorded by the camera unit 101 and provide the obtained information to the driver. Such a camera unit 101 may be used as a driving assistance device.

The front radars 102 are installed in plurality at the front of the vehicle 500 and detect the distance between the vehicle 500 and objects in front of the vehicle 500. The rear radars 104 are installed in plurality at the rear of the vehicle 500 and detect the distance between the vehicle 500 and objects behind the vehicle 500. When there is object information detected through the radars 102 and 104, alarms or warning messages indicating there is a nearby object or an obstacle is notified to the driver.

The GPS sensor 103 may receive signals from satellites and provide the received signals to devices such as the vehicle control module 212, the LiDAR device 100, and the camera unit 101. Additionally, these devices may provide or calculate information regarding the vehicle's position, speed, and time based on GPS location signals.

The ultrasonic sensor 105 may sense the distance to nearby vehicles or obstacles, providing convenience for safely parking the vehicle in a parking space. Additionally, the ultrasonic sensor 105 may prevent accidents that may occur during driving. The ultrasonic sensor 105 may be installed at the rear, sides, wheels, or other parts of the vehicle.

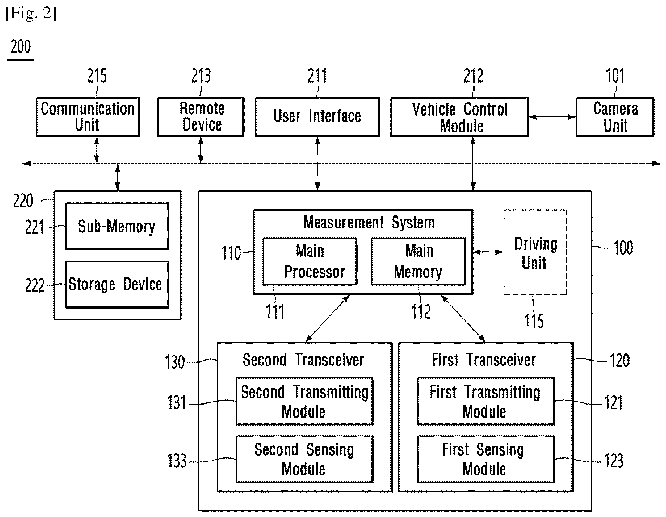

As shown in FIG. 2, a vehicle system 200 with the LiDAR device 100 and the vehicle control module 212 may receive inputs from a user or driver or provide information to the user or driver through a user interface 211. The user interface 211 may include a display device, touch panel, buttons, voice recognition, or wired/wireless input devices, and connect the driver and various devices via wired or wireless connections to enable communication.

The vehicle system 200 may communicate with a remote device 213, which may remotely communicate with a user or externals, or receive external control signals. A communication unit 215 may support wired or wireless communication to enable such communication and, for example, may be a wired or wireless module.

The storage unit 220 may include one or more sub-memories 221 inside. Additionally, the storage unit 220 may include a portable or detachable storage device 222. The LiDAR device 100 may communicate with the user interface 211 and the camera unit 101.

The LiDAR device 100 may include a driving unit 115 such as a motor, and the driving unit 115 may rotate a part or the entirety of the LiDAR device 100 by 360 degrees based on control signals. The driving unit 115 may communicate with internal components of the LiDAR device 100, such as a measurement system 110, enabling axial rotation of the LiDAR device 100.

The LiDAR device 100 may include a measurement system 110 and at least one transceiver 120 and 130. The driving unit 115 is coupled to the measurement system 110 and the transceivers 120 and 130 to transmit driving power, thereby allowing rotation.

The measurement system 110 may include a main processor 111 and a main memory 112. The main processor 111 may be implemented as a general-purpose processor, an ASIC (Application-Specific Integrated Circuit), one or more FPGAs (Field Programmable Gate Arrays), a group of processing components, or other suitable electronic processing components. The main memory (e.g., memory, memory unit, storage device, etc.) 112 may include one or more devices (e.g., RAM, ROM, flash memory, hard disk storage, etc.) for storing data and/or computer code to complete or facilitate various processes described in the present invention. The main memory 112 may be volatile or non-volatile memory or may include both the volatile memory and the non-volatile memory. The main memory 112 may include database components, object code components, script components, or any other type of information structure to support various activities and information structures described in the present invention. According to an embodiment, the main memory 112 may be communicably connected to the main processor 111.

The measurement system 110 may include one or more processors (also referred to as central processing units or CPUs). The one or more processors may be connected to a communication infrastructure or bus. Additionally, each of the one or more processors may be a graphics processing unit (GPU). In some examples, GPUs may include processors which are specialized electronic circuits configured to handle mathematically intensive applications. GPUs may have parallel structures that are efficient for parallel processing large blocks of data, such as mathematically intensive data commonly used in computer graphics applications, images, videos, etc.

The measurement system 110, as a computer system, may be connected to one or more user input/output devices such as a monitor, keyboard, pointing device, etc., which communicate with the communication infrastructure via a user input/output interface.

Within the LiDAR device 100, one or more transceivers 120 and 130 may be disposed, for example, as a plurality. The plurality of transceivers 120 and 130 may emit and sense laser beams in different directions relative to the axis of rotation. Here, the different directions may range from 10 degrees to 180 degrees relative to each other, and may be disposed, for example, at angles of 30 degrees, 60 degrees, 90 degrees, 120 degrees, 150 degrees, or 180 degrees, preferably disposed at an angle of 180 degrees.

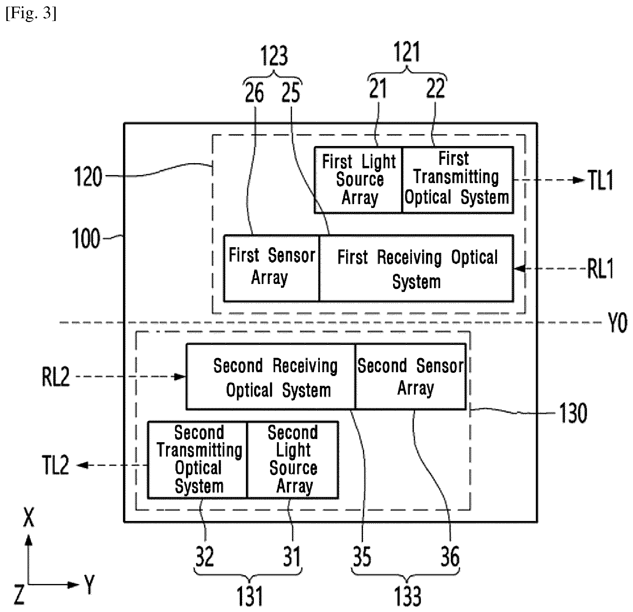

As shown in FIG. 3, the plurality of transceivers 120 and 130 may emit and sense laser beams in opposite directions. To this end, light source arrays 21 and 31 of the plurality of transceivers 120 and 130 may be disposed on opposite sides, and receiving optical systems 25, 35 may be arranged in opposite directions from the center of the interior of the LiDAR device 100.

The plurality of transceivers 120 and 130 may have different divergence angles or fields of view. The plurality of transceivers 120 and 130 may scan objects at different altitudes. By equipping plurality of transceivers 120 and 130 inside, the rotating imaging device may be miniaturized, and as the weight is distributed, rotational balance may be achieved. The plurality of transceivers 120 and 130 may have vertical fields of view (i.e., altitudes) that differ from each other. The plurality of transceivers 120 and 130 may have horizontal fields of view that differ from each other.

The plurality of transceivers 120 and 130 may include a first transceiver 120 and a second transceiver 130. The first transceiver 120 may include a first transmitting module 121 and a first sensing module 123, and the second transceiver 130 may include a second transmitting module 131 and a second sensing module 133. The first transmitting module 121 of the first transceiver 120 transmits a laser beam, and the first sensing module 123 senses the laser beam transmitted by the first transmitting module 121. The second transmitting module 131 of the second transceiver 130 transmits a laser beam, and the second sensing module 133 senses the laser beam transmitted by the second transmitting module 131.

As shown in FIG. 3, the first transmitting module 121 may include a first light source array 21 and a first transmitting optical system 22. The first sensing module 123 may include a first receiving optical system 25 and a first sensor array 26. The first transmitting module 121 transmits a first transmitting laser beam TL1 toward an object, and the first sensing module 123 senses a first receiving laser beam RL1 reflected from the object.

The second transmitting module 131 may include a second light source array 31 and a second transmitting optical system 32. The second sensing module 133 may include a second receiving optical system 35 and a second sensor array 36. The second transmitting module 131 transmits a second transmitting laser beam TL2 toward an object, and the second sensing module 133 senses a second receiving laser beam RL2 reflected from the object.

The first transmitting laser beam TL1 is emitted in a first direction Y, and the second transmitting laser beam TL2 is emitted in the opposite direction to the first direction. In other words, the first and second transmitting laser beams TL1 and TL2 emit light in opposite directions, 180 degrees, relative to a central position, and scan objects arranged along the 180-degree range.

The first and second transmitting modules 121 and 131 may include processors or control modules, such as general-purpose processors, ASIC, or FPGA, capable of controlling the driving control and transmission of optical signals from the first and second light source arrays 21 and 31, and may also include internal memory storing codes for controlling laser beam generation.

The first and second light source arrays 21 and 31 may include one-dimensional or two-dimensional arrays and may be individually addressable or controllable. The first and second light source arrays 21 and 31 may include a plurality of light sources that generate laser beams or light pulses. The light sources may include light sources of laser diode LD, edge-emitting laser, vertical-cavity surface-emitting laser VCSEL, distributed feedback laser DFB, light-emitting diode LED, and super luminescent diode SLD, among others. However, the light sources are not limited thereto.

The first and second light source arrays 21 and 31 may include a plurality of electrically connected surface-emitting laser diodes, such as VCSEL arrays, and each emitter may be individually addressable or controllable. The first and second light source arrays 21 and 31 may be implemented as a one-dimensional (Q*P) VCSEL array or a two-dimensional array with Q rows and P columns. Here, Q and P (columns, rows) may be greater than or equal to 2(Q > P). Additionally, each VCSEL array may be grouped into a plurality of units to form each light source. The number of light sources in the first and second light source arrays 21 and 31 may be the same or different.

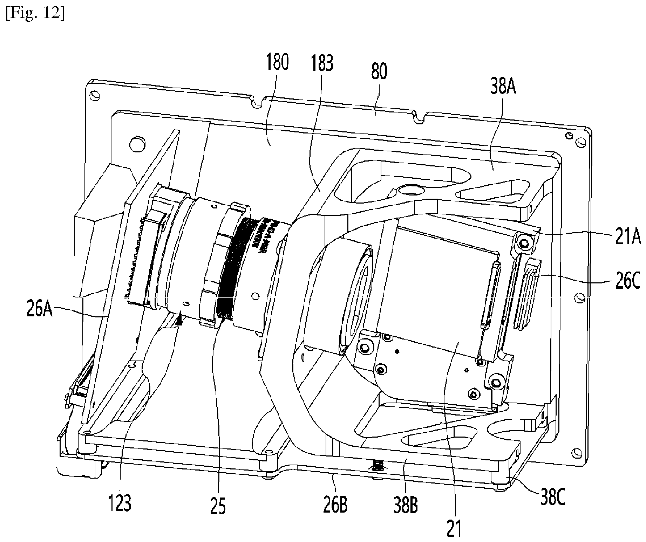

The optical signals emitted from the first and second light source arrays 21 and 31 may be irradiated toward objects through the first and second transmitting optical systems 22 and 32. The first and second transmitting optical systems 22 and 32 may include one or more lenses or may include one or more lenses and a micro-lens array 26C and 36C (refer FIG. 12) disposed in front of the lenses. The first and second transmitting optical systems 22 and 32 may include one or more optical lens elements to modify the laser beams as desired. In other words, the first and second transmitting modules 121, 131 may set the irradiation direction or angle of light generated from the first and second light source arrays 21 and 31 according to the control of the main processor 111. Additionally, the LiDAR device 100 may include a beam splitter (not shown) inside to overlap or separate the first transmitting laser beam TL1 and the first receiving laser beam RL1.

The first and second transmitting modules 121 and 131 may irradiate pulsed light or continuous light and may transmit a plurality of times toward the object to be scanned. The main processor 111 may generate a start signal at the time of light transmission and provide the start signal to a time-to-digital converter (TDC). The start signal may be used for calculating the time of flight (TOF) of the light.

The first and second sensing modules 123 and 133 may convert raw histograms based on signals sensed through the first and second receiving optical systems 25 and 35 and may include processors with a matched filter, a peak detection circuit, a SPAD(Single Photon Avalanche Diode) saturation circuit, and a SPAD quenching circuit. Such processors may be implemented by general-purpose processors, application-specific integrated circuits (ASICs), one or more field-programmable gate arrays (FPGAs), a group of processing components, or other suitable electronic processing components. The first and second sensing modules 133, 133 may also include a memory (not shown) having one or more devices (e.g., RAM, ROM, flash memory, hard disk storage, etc.) for storing detected optical signals internally.

The first and second sensor arrays 26 and 36 may receive laser beams RL1 and RL2 reflected or scattered from objects through the first and second receiving optical systems 22 and 32. These first and second sensor arrays 26 and 36 may include detectors divided into a plurality of pixels, and each of the plurality of pixels may be equipped with optical detection elements. The first and second receiving optical systems 22 and 32 may be optical elements configured to focus the reflected light onto specific pixels.

When the reflected light is received by the first and second sensor arrays 26 and 36, the first and second sensing modules 123 and 133 may convert the reflected light into stop signals. These stop signals, with the start signal, may be used for calculating the time of flight of the light. The first and second sensor arrays 26 and 36 or the first and second sensing modules 123 and 133 may include TDCs (Time-to-Digital Converters) for measuring the time of flight of light detected by each of the plurality of photodetectors. The photodetectors may be light-receiving elements that generate electrical signals based on detected optical energy.

The first and second sensor arrays 26 and 36 may be implemented as one-dimensional or two-dimensional arrays and may be photodetectors, such as a set of SPADs (Single Avalanche Photon Diodes), etc., or single-photon detector(APD: Avalanche Photo Diode). An embodiment of the present invention may be implemented using single-photon detectors. The first and second sensor arrays 26 and 36 measure light pulses, i.e., light corresponding to image pixels, through the first and second receiving optical systems 25 and 35. For example, the first and second sensor arrays 26 and 36 may be arranged as two-dimensional SPAD arrays with M rows and N columns, where M and N may be 2 or greater. Additionally, each SPAD sub-array may be grouped into a plurality of units to form optical sensors. For instance, the first and second sensor arrays 26, 36 may be in Geiger mode, i.e., Geiger-mode APD (GmAPD).

The main processor 111 processes signals to obtain information about objects using the light detected by the first and second sensing modules 123 and 133. The main processor 111 determines the distance to an object based on the time of flight (TOF) of light reflected from the object and processes data for analyzing the position and shape of the object. The information analyzed by the processor 111, i.e. information of the shape and position of the object, may be transmitted to other devices.

The first and second transmitting optical systems 22 and 32 irradiate the light pulses toward an object by refracting light pulses generated by the first and second light source arrays 21 and 31. Also, the light pulses are incident on and reflected from the surface of the object. Also, the reflected light pulses may be sensed by the first and second sensor arrays 26, 36 through the first and second receiving optical systems 25 and 35. Based on the elapsed time (TOF: Time of Flight) from the emission of the light pulses to the detection of the reflected light pulses, the distance or depth to the object may be determined. The LiDAR device 100 may provide scenes or situations around the vehicle using the obtained data, or may combine the obtained data with one or more image data acquired by the camera unit 101 to gain additional insights.

As shown in FIG. 3, the first transceiver 120 is disposed on one side with respect to a central axis Y0 passing horizontally through the LiDAR device 100 in a first direction Y, and the second transceiver 130 is disposed on the opposite side. Since the first and second transceivers 120 and 130 are distributed and disposed on both sides of the central axis Y0, the weight balance or rotational balance of the LiDAR device 100 may be achieved. The central axis Y0 may be a straight line passing through the center between both sides of the LiDAR device 100 in a second direction X.

The first transceiver 120 transmits and receives a first laser beam L1 in the first direction Y. The first transceiver 120 transmits and receives a second laser beam L2 in the direction opposite to the first direction Y. Accordingly, optical interference by the transmission and reception of the first and second laser beams L1, L2 may be prevented. Furthermore, the gap between the first transmitting optical system 22 and the second transmitting optical system 32 may be further apart than the gap between the first receiving optical system 25 and the second receiving optical system 35.

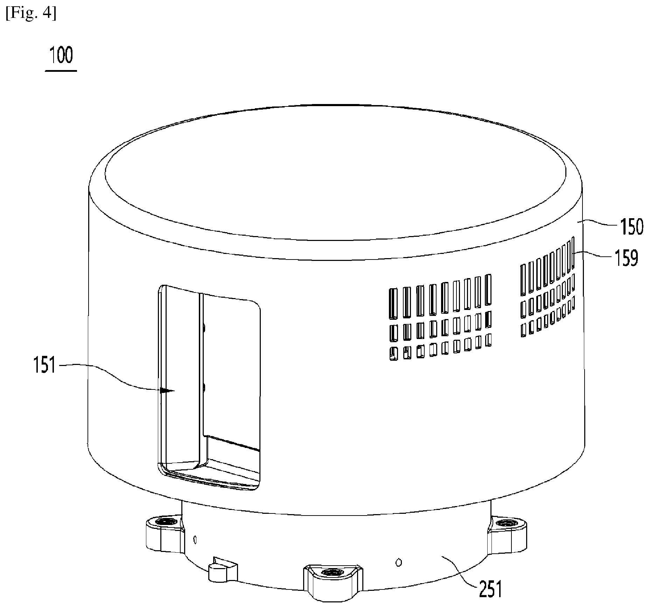

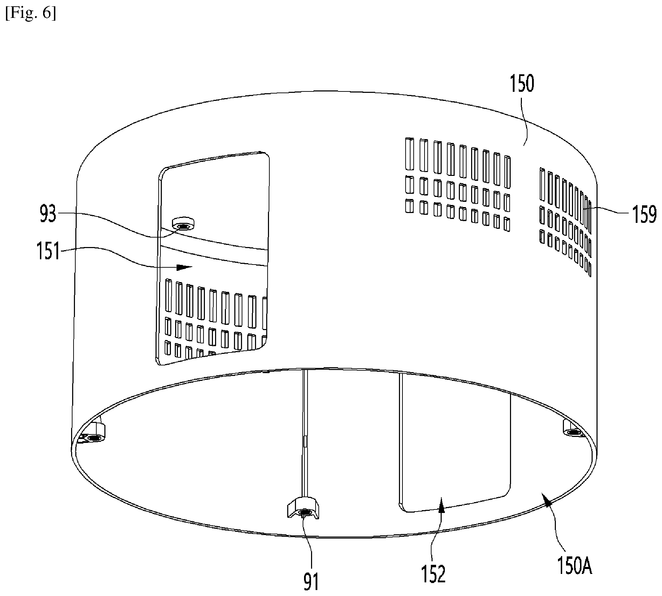

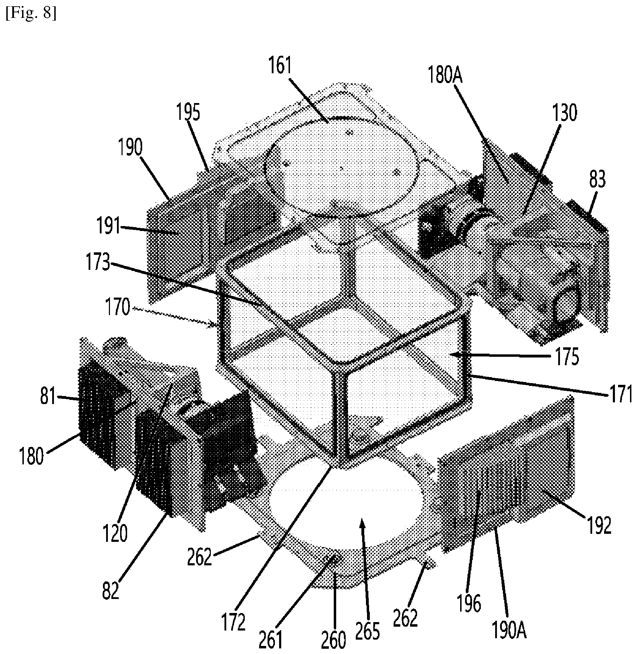

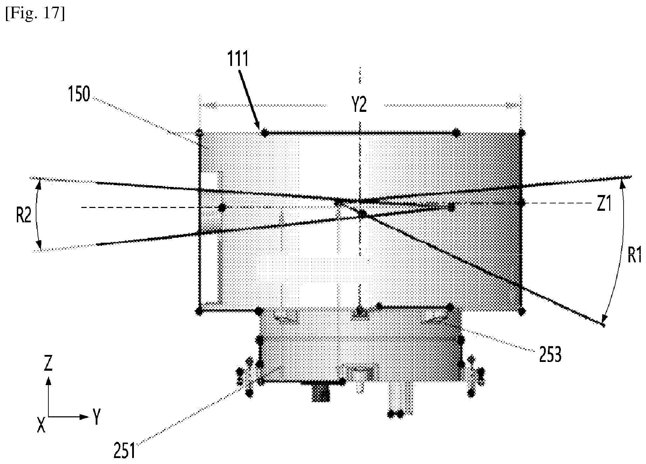

As shown in FIGS. 4 to 8, the LiDAR device 100 may include a fixed frame 251, a rotating frame 253 (refer to FIG. 17), a housing 150, a main frame 170 within an internal space 150A of the housing 150, and transceivers 120 and 130.

The fixed frame 251 includes a stator inside and may be fixed to a cover or an upper case of a vehicle or a movable body. The fixed frame 251 is provided with a fastening portion 12 along the fixed frame's 251 outer periphery and may be coupled to a vehicle such as a movable body using a plurality of fastening members 11. A top view shape of the fixed frame 251 may include a circular shape or a ring shape.

As shown in FIG. 17, the rotating frame 253 faces the internal structure of the fixed frame 251, includes a rotor (not shown), and may rotate on the fixed frame 251. The stator may be a coil, and the rotor may be a coil. The stator and rotor may include a driving unit, such as a motor. Structures may be arranged in one or more regions of the rotating frame 253 and the fixed frame 251 to guide the rotation of the rotating frame 253 and prevent detachment. Also, these structures may include a rotation guide or a rotation shaft (not shown). A top view shape of the rotating frame 253 may include a circular shape or a ring shape. The rotating frame 253 may be a rotating platform.

As shown in FIGS. 4 to 6, the internal space 150A of the housing 150 may have a cylindrical shape with an open bottom and a closed top. The housing 150 may extend outward above the rotating frame 253. The housing 150 may rotate together with the rotating frame 253. The housing 150 may function as an enclosure covering internal components and may be formed from a heat-dissipating material.

A plurality of perforations 159 may be arranged in a predetermined region of the peripheral surface of the housing 150 for heat dissipation. The perforations 159 may be arranged in plurality in the vertical and rotational directions in at least two regions. The perforations 159 may each be of the same size, or at least one of the perforations 159 may be formed with a different size.

The housing 150 may include at least one window hole 151 and 152. The window holes 151 and 152 may be formed to a predetermined size between the top and bottom of the housing 150 and may, for example, be larger than the size of the windows 191 and 192 through which light of each transceiver 120 and 130 is transmitted and received. The window holes 151 and 152 may be disposed in the entrance region of each window 191 and 192 to expose the windows 191 and 192.

A rotating head 111 is coupled to the upper part of the rotating frame 253 and the interior of the housing 150. Also, the rotating head 111 may be provided in a cylindrical shape and may rotate together with the rotating frame 253. A cover frame 141 of the rotating head 111 blocks the inflow of foreign substances into the internal space where internal components, such as the transceivers 120 and 130 and other components, are accommodated. The cover frame 141 may have a circular shape or a polygonal shape and may be made of a metal frame material or a transparent plastic material.

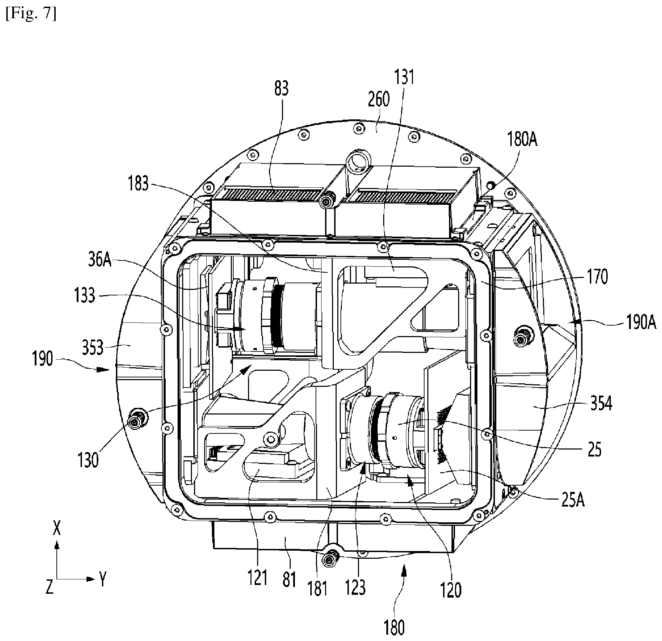

One or more cover frames 141 may be stacked and may be tightly coupled to the main frame 170, as shown in FIG. 7. Here, tight coupling involves the coupling of two structures that have a mating structure or a stepped structure, may be fastened by a plurality of fastening members, and may include sealing members to prevent moisture penetration from the outside.

The bottom frame 260 supports the components of the rotating head 111. The bottom frame 260 may be a circular shape and may have a diameter larger than that of the fixed frame 251. One or more bottom frames 260 may be stacked. The bottom frame 260 may have an area larger than the bottom area of the main frame 170, as shown in FIG. 7.

The cover frame 141 may be fastened to a first fastening portion 93 disposed along the inner upper circumference of the housing 150 using fastening members (not shown). The bottom frame 260 may be fastened to a second fastening portion 91 disposed along the inner lower circumference of the housing 150 using fastening members (not shown). The cover frame 141 may have a different shape or the same shape as the upper cover 161 and 162 described later, and one of the upper covers 161 and 162 may be removed.

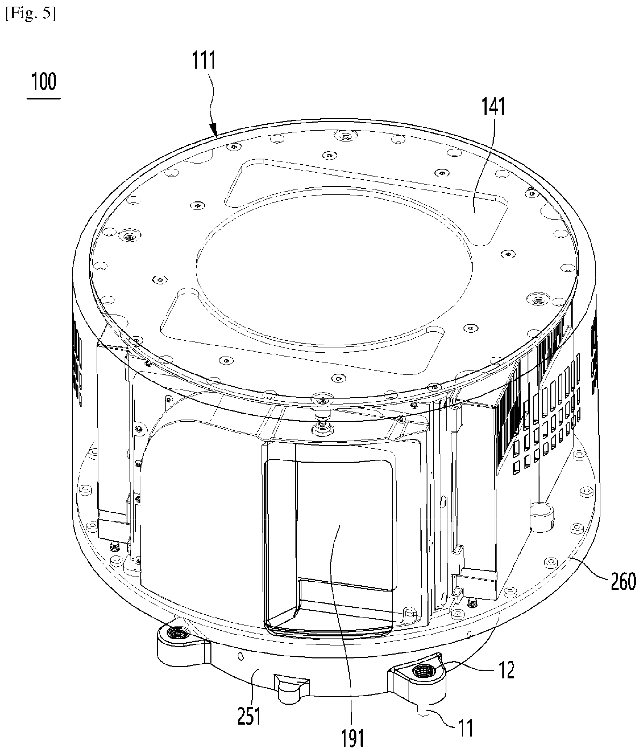

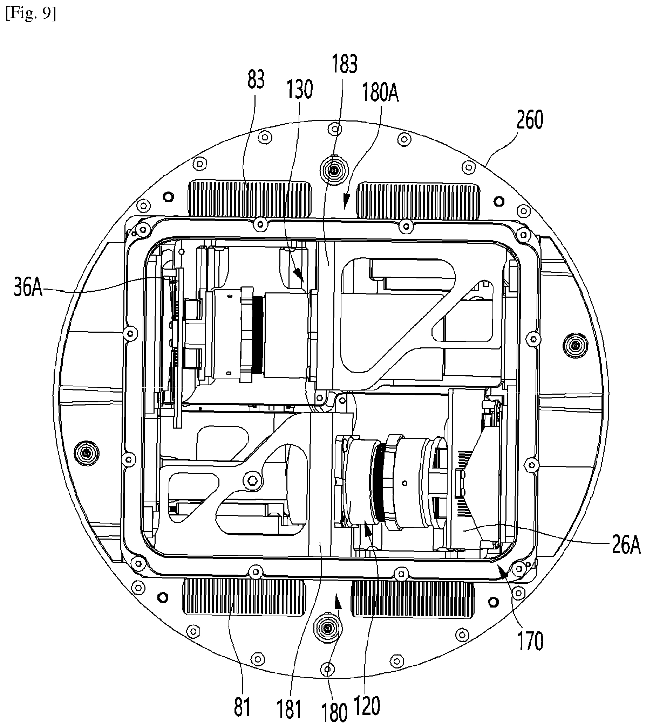

As shown in FIGS. 7 to 12, the LiDAR device 100 may include optical elements, such as transceivers 120 and 130, heat dissipation elements for heat dissipation, frame elements for supporting and coupling internal components, and cover elements for protecting internal components within the housing 150. The rotating head 111, shown in FIG. 5, may include optical elements, heat dissipation elements for heat dissipation, frame elements for supporting and coupling internal components, and cover elements for protecting internal components.

The optical elements include at least one transceiver, for example, the first and second transceivers 120 and 130. The first transceiver 120 may include one or more circuit boards 21A, 26A, and 26B electrically connected to the first light source array 21 and/or the first sensor array 26. The first sensor array 26 may be disposed on a first circuit board 26A, and the first light source array 21 may be disposed on another driver board 21A. The first transceiver 120 may be disposed on a first main board 26B, and the first main board 26B may be electrically connected to the above-described boards. The first light source array 21, a driver board 21A to drive the first light source array 21, the first sensor array 26, and the first circuit board 26A to drive the first sensor array 26 may be heat-generating components. If heat issues of these heat-generating components are not resolved, the heat issues may affect operation or driving and may reduce the reliability of products. The first main board 26B may be spaced apart from the heat-generating components or disposed on the bottom frame 260 to prevent issues caused by heat.

The second transceiver 130 may include one or more circuit boards 31A, 36A, and 36B electrically connected to the second light source array 31 and/or the second sensor array 36. The second sensor array 36 may be disposed on a second circuit board 36A, and the second light source array 31 may be disposed on another driver board 31A. The second transceiver 130 may be disposed on a second main board 36B, and the second main board 36B may be electrically connected to the above-described boards. The second light source array 31, a driver board 31A to drive the second light source array 31, the second sensor array 36, and a second circuit board 36A to drive the second sensor array 36 may be heat-generating components. If heat issues of these heat-generating components are not resolved, the heat issues may affect operation or driving and may reduce the reliability of products. The second main board 36B may be spaced apart from the heat-generating components or disposed on the bottom frame 260 to prevent issues caused by heat.

The first circuit board 26A may be disposed between the first receiving optical system 25 and the main frame 170. The second circuit board 36A may be disposed between the second receiving optical system 35 and the main frame 170. The first circuit board 26A and the second circuit board 36A may be disposed on opposite sides of the main frame 170. Likewise, by arranging the first and second transceivers 120 and 130 in opposite directions, light source arrays, sensor arrays, and circuit boards of each transceiver may be distributed, thereby improving heat dissipation efficiency and maximizing space utilization. Additionally, by providing a cooling system with heat dissipation members on at least three sides of each transceiver, heat issues of heat-generating components or issues of reduced heat dissipation may be improved, and performance degradation of the LiDAR system due to heat may be prevented.

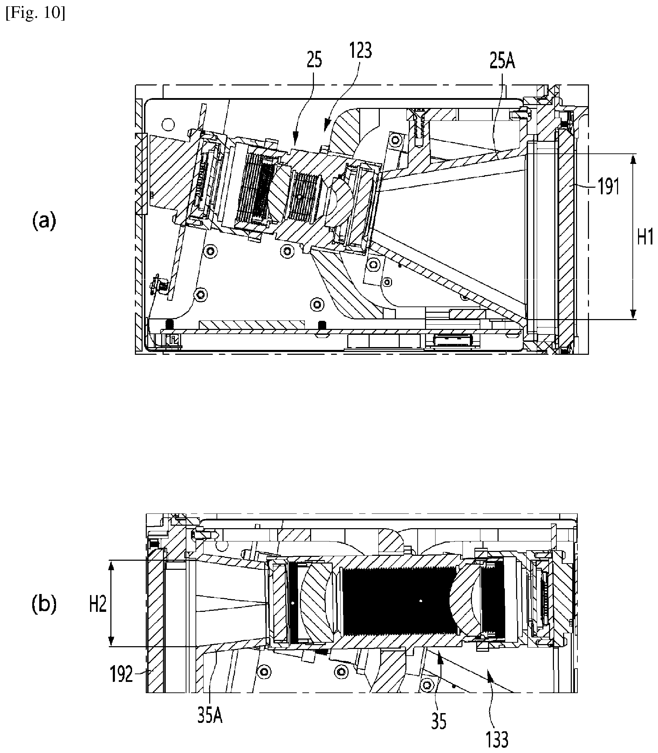

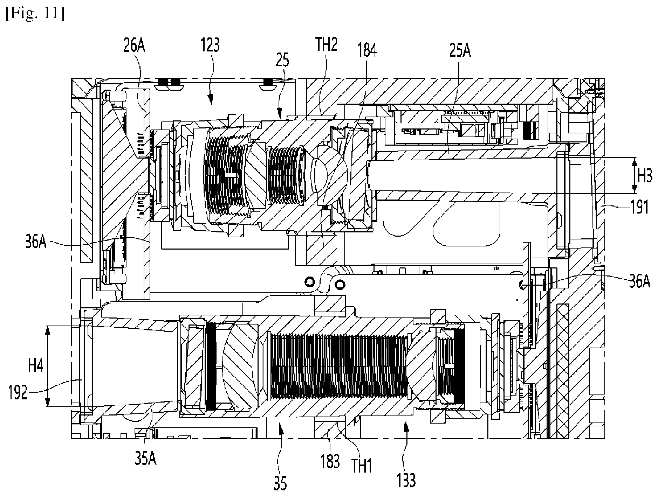

As shown in FIGS. 10 and 11, the first transceiver 120 may include a first lens tube 25A receiving light on the incident side (front) of the first receiving optical system 25. The second transceiver 130 may include a second lens tube 35A for receiving light on the incident side (front) of the second receiving optical system 35. The shape or area of the entrance side of the first lens tube 25A may differ from the shape or area of the entrance side of the second lens tube 35A. The first lens tube 25A may be a part of the first receiving optical system 25. The second lens tube 35A may be a part of the second receiving optical system 35.

Here, the first transceiver 120, the first lens tube 25A, and the circuit boards 21A, 26A, 26B may be defined as a first transceiver assembly. The second transceiver 130, the second lens tube 35A, and the circuit boards 31A, 36A, and 36B may be defined as a second transceiver assembly.

The first lens tube 25A extends between a first lens of the first receiving optical system 25 and a first window 191, which may improve incident efficiency and protect the lenses. The second lens tube 35A extends between a first lens of the second receiving optical system 35 and a second window 192, which may improve incident efficiency and protect the lenses.

The vertical aperture height H1 of the first lens tube 25A may differ from the vertical aperture height H2 of the second lens tube 35A, for example, may be greater than the vertical aperture height H2 of the second lens tube 35A. The horizontal aperture length H3 of the first lens tube 25A may differ from the horizontal aperture length H4 of the second lens tube 35A, for example, may be smaller than the horizontal aperture length H4 of the second lens tube 35A. When viewed from the side cross-section, a first optical axis passing through the center of the first lens tube 25A and the centers of the internal lenses may be inclined relative to a second optical axis passing through the center of the second lens tube 35A and the centers of the internal lenses. The second optical axis is a horizontal optical axis, and the first optical axis may be inclined relative to the second optical axis.

The first light source array 21 may be disposed outside the first lens tube 25A, and the second light source array 31 may be disposed outside the second lens tube 35A. Each of the lens tubes may be a lens hood.

The vertical field of view of the first receiving optical system 25 may differ from the vertical field of view of the second receiving optical system 35, for example, may be greater than the vertical field of view of the second receiving optical system 35. The horizontal field of view of the first receiving optical system 25 may differ from the horizontal field of view of the second receiving optical system 35, for example, may be smaller than the horizontal field of view of the second receiving optical system 35. Additionally, the horizontal and horizontal field of view of the first receiving optical system 25 may differ from each other. The horizontal and vertical fields of view of the second receiving optical system 35 may be the same. That is, among the plurality of transceivers 120 and 130, one may have different horizontal and vertical reception fields of view, while the other may have identical horizontal and vertical fields of view.

The first receiving optical system 25 of the first transceiver 120 may be arranged to extend long from a third side to a fourth side of the main frame 170. The second receiving optical system 35 of the second transceiver 130 may be arranged to extend long from the fourth side to the third side of the main frame 170. The third and fourth sides may be both sides of the main frame 170 in the first direction Y, while the first and second sides may be both sides of the main frame 170 in the second direction X. Each of the first to fourth sides of the main frame 170 may include through accommodation parts. And elements for heat dissipation, i.e. frames with heat dissipation members may be coupled in the accommodation parts of each side.

The main frame 170 may include a accommodation part 175 that accommodates the first transceiver 120 and the second transceiver 130 inside. The main frame 170 may include a plurality of pillar frames 171, a lower frame 172, and an upper frame 173. The upper frame 173, lower frame 172, and pillar frames 171 may include a plurality of accommodation parts, i.e., fascia, for example, may include six accommodation parts or fascia.

The upper frame 173, lower frame 172, and a plurality of pillar frames 171 may be integrally provided. As another example, at least one of the upper frame 173, lower frame 172, and the plurality of pillar frames 171 may be provided as a separable structure. The upper frame 173 or lower frame 172 may be provided separately, and the the plurality of pillar frames 171 may be coupled to the upper frame 173 or lower frame 172. At least one of the upper frame 173, lower frame 172, and the plurality of pillar frames 171 may be coupled to allow fastening or detachment.

The upper frame 173 and the lower frame 172 may be spaced apart from each other by the pillar frames 171 and may have a polygonal frame shape. The upper frame 173 may be a polygonal shape or a circular shape with a penetrated interior. The lower frame 172 may be a polygonal shape or a circular shape with a penetrated interior. The upper and lower frames 172 may be the same polygonal shape, for example, a rectangular shape.

The pillar frames 171 may connect and support each corner of the upper and lower frames 172. The upper frame 173, the lower frame 172, and the pillar frames 171 may be integrally formed. As another example, the upper frame 173 may be composed of one or more than two parts, or the lower frame 172 may be composed of one or more than two parts. Additionally, at least one of the upper and lower frames 172 may be integrally coupled to the pillar frames 171 or may have a coupleable structure.

The upper frame 173 may have a concave stepped structure along its inner circumference and may guide the coupling of upper covers 161 and 162 of a polygonal shape. The lower frame 172 may have a concave stepped structure along its inner circumference and may be coupled to the bottom frame 260 having a mating structure of a polygonal shape. Additionally, each of the pillar frames 171 may have a concave stepped structure in the respective side directions of the main frame 170 and may guide the coupling of outer frames.

The main frame 170 may be coupled with first to fourth frames 180, 180A, 190, and 190A in each side direction. The first and second frames 180 and 18A may be coupled to both sides of the main frame 170 in the second direction, and the third and fourth frames 190 and 190A may be coupled to both sides of the main frame 170 in the first direction. The first and second frames 180 and 180A may include concave stepped structures for mating with stepped structures arranged along the inner sides of both sides of the main frame 170. The third and fourth frames 190 and 190A may include concave stepped structures for mating with stepped structures arranged along the inner sides of both sides of the main frame 170.

The third frame 190 may include a first window 191 facing the first transmitting and receiving optical systems 22 and 25, and a third heat dissipation member 195 may be disposed on the outer side of the third frame 190. The fourth frame 190A may include a second window 192 facing the second transmitting and receiving optical systems 32 and 35, and a fourth heat dissipation member 196 may be disposed on the outer side of the fourth frame 190A.

The first transceiver 120 may be coupled inside the first frame 180, and a first heat dissipation member 81 and 81A may be disposed on the outer side of the first frame 180. The first heat dissipation member 81 and 81A may be disposed on the entire outer side or both outer sides of the first frame 180.

The second transceiver 130 may be coupled inside the second frame 180A, and a second heat dissipation member 83 and 83A may be disposed on the outer side of the second frame 180A. The second heat dissipation member 83 and 83A may be disposed on the entire outer side or both sides of the second frame 180A.

The first frame 180 may include a first support 183 inside, and the first support 183 may support a part of the first receiving optical system 25. The first support 183 may have a first barrel hole TH1 (refer to FIG. 11), and when the first receiving optical system 25 is inserted into the first barrel hole TH1, the position of the first receiving optical system 25 may be fixed and supported.

The second frame 180A may include a second support 184 inside, and the second support 184 may support a part of the second receiving optical system 35. The second support 184 may have a second barrel hole TH2 (refer to FIG. 11), and when the second receiving optical system 35 is inserted into the second barrel hole TH2, the position of the second receiving optical system 35 may be fixed and supported. The inner or outer sides of the first and second barrel holes TH1 and TH2 may further include locking means to secure the receiving optical systems, and the locking means may include fasteners.

The first and second supports 183 and 184 may be provided as thermally conductive metal materials, such as at least one of iron alloys, aluminum alloys, or magnesium alloys, and may be provided as mounting devices for circuit boards, thereby improving heat dissipation efficiency in the internal space. Additionally, the outer sides of the first and second supports 183 and 184 may further include cooling fins.

The first frame 180 may include a first protection part 38A extending from the first support 183 to the upper side of the first light source array 21 and a second protection part 38B extending from the first support 183 to the lower side. The first and second protection parts 38A and 38B may be bent from the first support 183, and the second protection part 38B may be spaced apart from the first main board 26B by a spacer 38C. The gap between the first and second protection parts 38A and 38B may be greater than the outer diameter of the first lens tube 25A, thereby protecting the lens tube 25A.

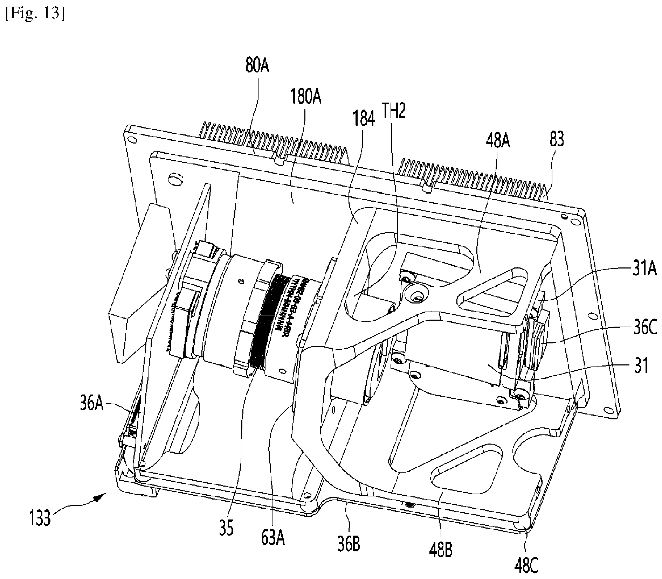

As shown in FIG. 13, the second frame 180A may include a third protection part 48A extending from the second support 184 to the upper side of the second light source array 31 and a fourth protection part 48B extending from the second support 184 to the lower side. The third and fourth protection parts 48A and 48B may be bent from the second support 184, and the fourth protection part 48B may be spaced apart from the second main board 36B by a spacer 48C. The gap between the third and fourth protection parts 48A and 48B may be greater than the outer diameter of the second lens tube 35A, thereby protecting the second lens tube 35A.

Additionally, the first and second protection parts 38A and 38B of the first support 183 and the third and fourth protection parts 48A and 48B of the second support 184 may include holes inside, thereby suppressing an increase in weight. The first support 183 may be integrally formed on or separately attached to the inside of the first frame 180. The second support 184 may be integrally formed on or separately attached to the inside of the second frame 180A. The inner circumference of the first frame 180 may have a stepped structure and may be coupled to the third side of the main frame 170. The inner circumference of the second frame 180A may have a stepped structure and may be coupled to the fourth side of the main frame 170.

The main frame 170 may be coupled to one or more upper covers 161 and 162. The perimeter of the upper cover 161 and 162 may be inserted into or adhered to the upper frame 173 of the main frame 170. The upper covers 161 and 162 may have a plurality of fastening holes on interior or perimeter thereof and may be fastened to the frames coupled to the main frame 170. The upper covers 161 and 162 may be transparent or opaque.

The upper covers 161 and 162 may be fastened to fastening portions on the inner side of the housing 150. The upper covers 161 and 162 may be circular or polygonal in shape. That is, the upper covers 161 and 162 may be a circular shape identical to the upper shape of the housing 150. As another example, the upper covers 161 and 162 may be a polygonal shape identical to the upper shape of the main frame 170.

The main frame 170 may be coupled to the bottom frame 260. The bottom frame 260 may support the lower portions of the first and second transceivers 120 and 130. The bottom frame 260 may be coupled to the rotating frame 253. The bottom frame 260 may include coupling holes inside and coupling protrusions on the upper perimeter, and may be mated with the lower frame 172 of the main frame 170 by the stepped structure on the upper perimeter, ensuring adherence. Accordingly, the lower frame 172 may be adhered to the perimeter of the bottom frame 260.

The upper structure of the rotation frame 253 may protrude through the coupling holes of the bottom frame 260, and a component and/or a support component of the main frame 170 may be coupled to the coupling holes of the bottom frame 260. That is, to prevent movement caused by rotation, other frames and/or side covers may be coupled over the coupling holes of the bottom frame 260. Here, a plurality of frames 180, 180A, 190, and 190A may be coupled to respective sides of the main frame 170. The plurality of frames may be the first to fourth frames 180, 180A, 190, and 190A arranged on each side of the main frame 170.

The bottom frame 260 may have an external shape that is circular or polygonal, and may be coupled to the first to fourth frames 180, 180A, 190, and 190A using coupling protrusions 262 protruding outward from each side. The bottom frame 260 may include a plurality of insertion protrusions 261 along its inner perimeter, which may be coupled to holes (not shown) of the main boards 26B and 36B. These insertion protrusions 261 and coupling protrusions 262 may prevent individual movement of the bottom frame 260.

The bottom frame 260 may be coupled to the bottom of the housing 150. That is, the bottom frame 260 may have a circular shape identical to the lower shape of the housing 150. In another example, the bottom frame 260 may have a polygonal shape identical to the lower shape of the main frame 170. Sealing members may be disposed between each of the main frame 170 and the bottom frame 260, the main frame 170 and the upper cover 161, and the main frame 170 and the first to fourth frames 180, 180A, 190, and 190A. The sealing members, as cleaning elements, may include rubber materials, and may block moisture and foreign substances entering through each side of the main frame 170.

The first heat dissipation member 81 and 81A may be disposed on one side of the first circuit board 26A and one side of the first light source array 21. The first heat dissipation member 81 and 81A may be arranged on the outer side of heat-generating components such as the driver board 21A, the first circuit board 26A, and the second light source array 21, thereby dissipating heat generated from the heat-generating components. The first heat dissipation member 81 and 81A may be disposed between the housing 150 and the main frame 170. The second heat dissipation member 83 and 83A may be disposed on one side of the second circuit board 36A and one side of the second light source array 31. The second heat dissipation member 83 and 83A may be arranged on the outer side of heat-generating components such as the driver board 31A, the second circuit board 36A, and the second light source array 31, thereby dissipating heat generated from the heat-generating components. The second heat dissipation member 83 and 83A may be disposed between the housing 150 and the main frame 170. The first heat dissipation member 81 and 81A and the second heat dissipation member 83 and 83A may include heat dissipation fins, which may be arranged vertically and may be integrally formed with or connected to the first frame 180. The second heat dissipation member 83 and 83A may include heat dissipation fins, which may be arranged vertically and may be integrally formed with or connected to the second frame 180A. The first and second frames 180 and 180A may include thermally conductive materials, for example, metal materials.

The third heat dissipation member 195 may be arranged on the outer side of the first sensor array 26, i.e., on the outer side of the first circuit board 26A on which the first sensor array 26 is disposed, thereby dissipating heat generated by the first sensor array 26. The third heat dissipation member 195 may be arranged on the outer side of heat-generating components such as the first sensor array 26 and the first circuit board 26A, thereby dissipating heat generated from the heat-generating components. The fourth heat dissipation member 196 may be arranged on the outer side of the second sensor array 36, i.e., on the outer side of the second circuit board 36A on which the second sensor array 36 is disposed, thereby dissipating heat generated by the second sensor array 36. The fourth heat dissipation member 196 may be arranged on the outer side of heat-generating components such as the second sensor array 36 and the second circuit board 36A, thereby dissipating heat generated from the heat-generating components.

Heat dissipation fins may be formed on the third and fourth heat dissipation members 195 and 196. Also, the heat dissipation fins may be arranged vertically or in a curved shape, and may be integrally formed with or connected to the third and fourth frames 190 and 190A.

The respective areas of the third and fourth heat dissipation members 195 and 196 may be smaller than the respective areas of the first and second heat dissipation members 81A and 83A. The area of each heat dissipation member is the size of the region where each heat dissipation fin is arranged.

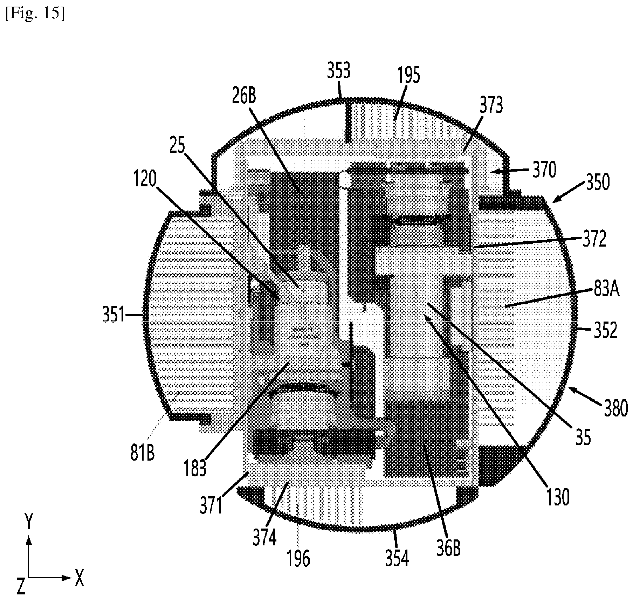

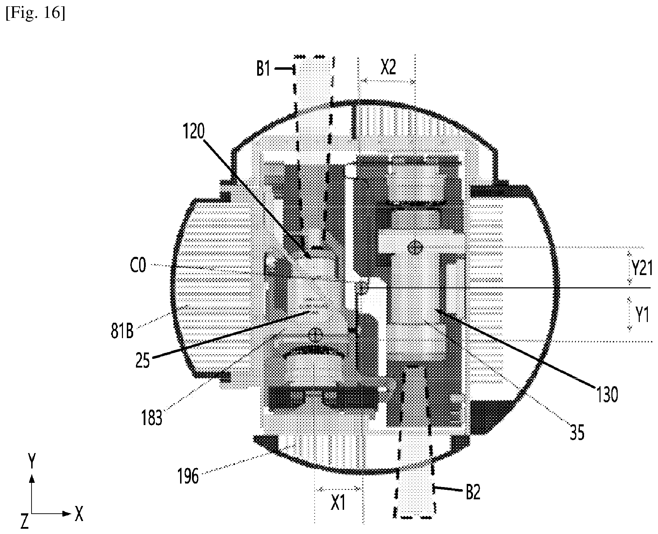

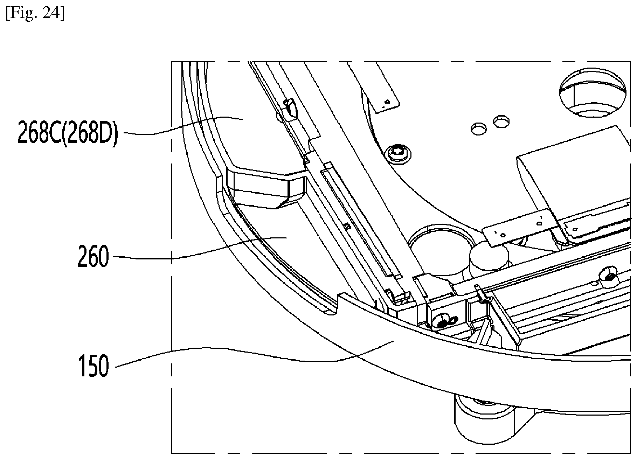

As shown in FIGS. 15 and 16, the first to fourth heat dissipation members 81A, 83A, 195, and 196 may be disposed inside the housing 150. The heat dissipation fins of the third and fourth heat dissipation members 195 and 196 may gradually decrease in width (horizontal width) along the rotational direction, while vertical lengths of the heat dissipation fins may remain the same. The first window hole 151 may face the first receiving optical system 22 and the first light source array 21 of the first transceiver 120, and the second window hole 152 may face the second receiving optical system 32 and the second light source array 31 of the second transceiver 130. The first and second windows 191 and 192 may be coupled to the coupling holes of the third and fourth frames 190 and 190A, respectively (refer to FIG. 24).

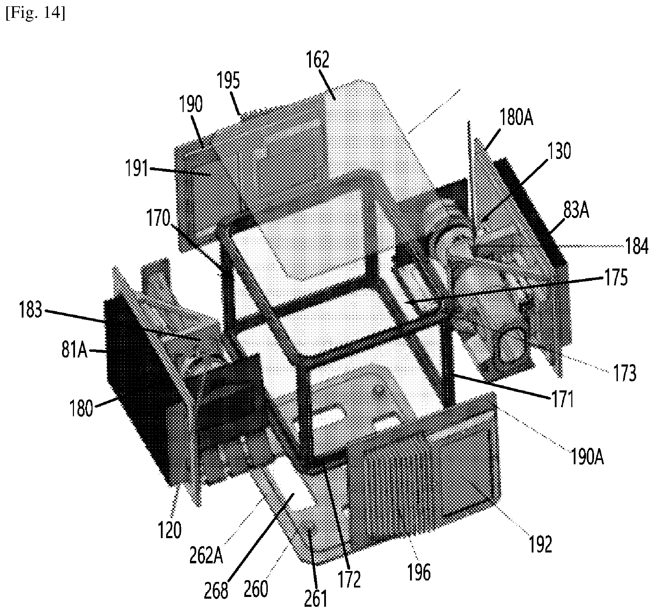

FIG. 14 is a view illustrating another example of the bottom frame 260. The bottom frame 260 may have a polygonal shape, and heat dissipation holes 268 may be arranged in areas corresponding to the lower regions of the heat dissipation fins of each heat dissipation member 81, 81A, 195, and 196.

The first window 191 may face the outer side of the first light source array 21 and the first receiving optical system 25. The first window 191 may face the lens tube 25A of the first receiving optical system 25 and the outer side of the first light source array 21. The second window 192 may face the outer side of the second light source array 31 and the second receiving optical system 35. The second window 192 may face the lens tube 35A of the second receiving optical system 35 and the outer side of the second light source array 31. The first window 191 is arranged on one side of the third heat dissipation member 195 or one side of the second circuit board 36A, and the second window 192 is arranged on the other side of the fourth heat dissipation member 196 or the other side of the first circuit board 26A.

FIG. 15 is a view illustrating another example of the housing 150 and/or heat dissipation members. As illustrated in FIG. 15, the LiDAR device may further include an inner cover 350 inside the housing 150. The inner cover 350 may be in close contact with the outer surfaces of the first to fourth heat dissipation members 81B, 83A, 195, and 196.

The inner cover 350 may include heat dissipation covers 351, 352, 353, and 354 on the outer sides of each heat dissipation member 81B, 83A, 195, and 196 of the main frame 370. The heat dissipation covers 351, 352, 353, and 354 may be disposed inside the housing 150. The heat dissipation covers 351, 352, 353, and 354 may be arranged between the housing 150 and the heat dissipation members 81B, 83A, 195, and 196. The heat dissipation covers 351, 352, 353, and 354 may be provided in a curved shape on the outer sides of each heat dissipation member 81B, 83A, 195, and 196. For example, a first heat dissipation cover 351 may be included on the outer side of the first heat dissipation member 81B, a second heat dissipation cover 352 on the outer side of the second heat dissipation member 83A, a third heat dissipation cover 353 on the outer side of the third heat dissipation member 195, and a fourth heat dissipation cover 354 on the outer side of the fourth heat dissipation member 196. When the heat dissipation members are disposed on the outer side of the main frame 170, a metal frame is disposed on the inner side, and a metal heat dissipation cover is disposed on the outer side, a dual heat dissipation effect may be provided. The heat dissipation covers may be made of other materials, such as a transparent material.

The first heat dissipation cover 351 may be coupled to one side of the main frame 370 with a hemispherical shape. The second heat dissipation cover 352 may be coupled to the other side of the main frame 370 with a hemispherical shape. Here, the outer shape of the heat dissipation fins of the first, third, and fourth heat dissipation members 81B, 195, and 196 may have different horizontal lengths to face the hemispherical heat dissipation covers 351, 353, and 354.

Adjacent heat dissipation covers 351, 352, 353, and 354 may be coupled to each other or may be coupled through the main frame 370. Additionally, the main frame 370 may be divided into a plurality of parts and coupled to each other using fastening members. Furthermore, the main frame 370 may be composed of frames 371, 372, 373, and 374 arranged on each side. In this case, by arranging the main frame 370 or each side frame, the number of frames may be reduced. Both ends of the third frame 190 may be bent, thereby facing the outer sides of one ends of the third and fourth frames. Each of the heat dissipation covers 351, 352, 353, and 354 may cover the outer side, both side surfaces, upper surface, and lower surface of each heat dissipation member 81B, 83A, 195, and 196.

As shown in FIG. 16, the first transceiver 120 may scan and sense in a first beam shape B1, and the second transceiver 130 may scan and sense in a second beam shape B2. At least one or all of the first and second transceivers may be provided without a lens tube.

The center of the first receiving optical system 25 and the center of the second receiving optical system 35 may be spaced apart by the same distance Y1 and Y2 in the first direction Y from the center C0 of the LiDAR device. The center of the first receiving optical system 25 and the center of the second receiving optical system 35 may be spaced apart by the same distance X1 and X2 in the second direction X from the center of the LiDAR device. When the weight center of each of the first and second transceivers 120 and 130 is the center position of the first and second receiving optical systems 25 and 35, the first and second transceivers 120 and 130 may be spaced apart equally in the first and second directions Y and X so that the weight center of each transceivers is disposed directly opposite the center of rotation.

As shown in FIG. 17, on the outer side of the housing 150, the first transceiver 120 may have a first vertical field of view R1, and the second transceiver 130 may have a second vertical field of view R2. With reference to a horizontal axis Z1, the second vertical field of view R2 may be smaller than the first vertical field of view R1. Here, the vertical field of view may refer to the angle between two straight lines extending from the top and bottom of the entrance side of each lens tube. The diameter Y2 of the housing 150 may be provided to be larger than the diameter of the rotating frame 253 and/or the fixed frame 251.

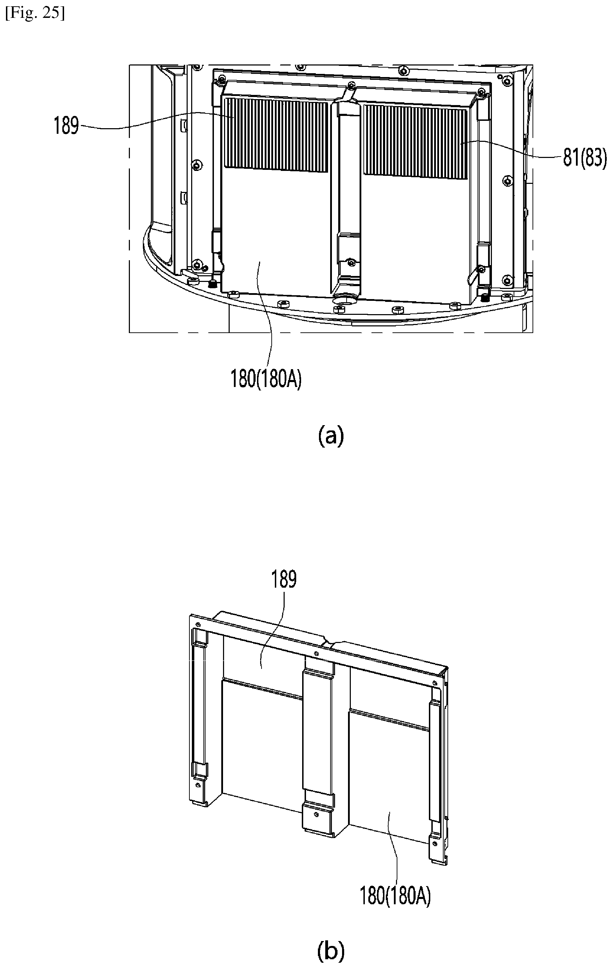

The third frame 190 may provide a window hole facing the first window 191 and may be coupled to a third heat dissipation cover 353 for covering the third heat dissipation member 195. The third heat dissipation cover 353 may protrude further outward than the first window 191, thereby protecting the first window 191. The fourth frame 190A may provide a window hole facing the second window 192 and may be coupled to a fourth heat dissipation cover 354 for covering the outer side of the fourth heat dissipation member 196. The fourth heat dissipation cover 354 may protrude further outward than the second window 192, thereby protecting the second window 192. As shown in FIG. 25, the outer edges of each window 191 and 192 may be provided as inclined surfaces 19S, and the inclined surfaces 19S may be closely fitted to the window holes of the third and fourth frames 190 and 190A. Additionally, the outer perimeters of each window 191 and 192 may be covered by the heat dissipation covers 353 and 354. Since these windows 191 and 192 are made of plastic material, expansion or contraction due to heat may occur. These windows 191 and 192 may be closely fitted to the frames 190, 190A or adhered with thermally conductive adhesive, and due to the outer heat dissipation covers 353, 354, the problem of optical loss caused by heat may be reduced.

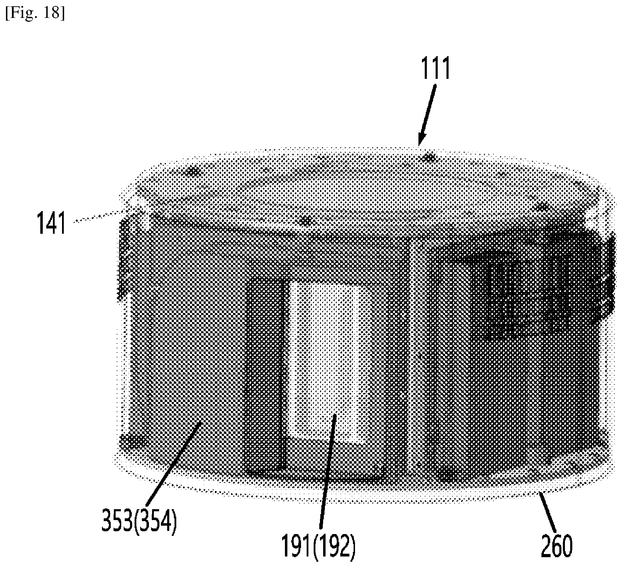

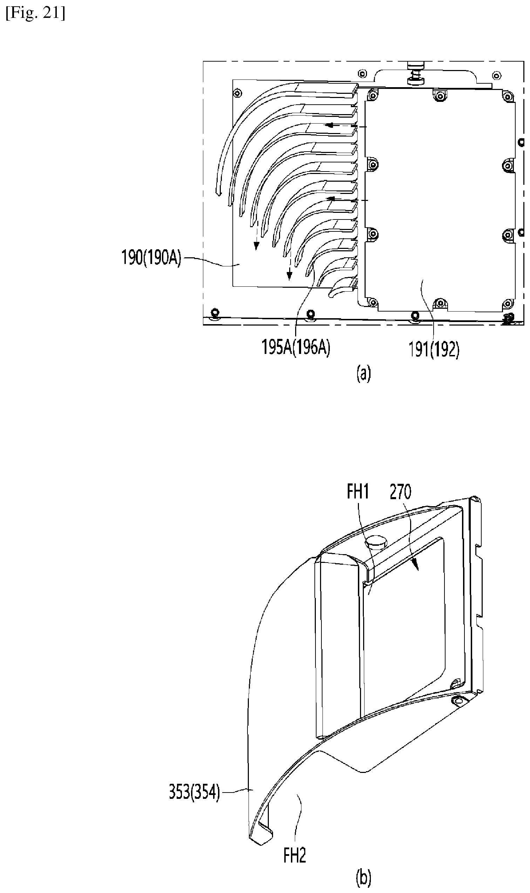

As shown in FIGS. 18 and 21, the third and fourth heat dissipation covers 353 and 354 may have window holes 270, may be fastened to the third and fourth frames 190 and 190A, and may have internal holes (not shown) where the windows 191 and 192 are coupled.

The third and fourth heat dissipation covers 353 and 354 may be disposed on the outer sides of the third and fourth heat dissipation members 195 and 196. The air guides 195A and 196A of the third and fourth heat dissipation members 195 and 196 may not be arranged vertically, and may have a curved shape. The air guides 195A and 196A may be heat dissipation fins integrally formed in the third and fourth frames 190 and 190A. Among the air guides 195A and 196A with the curved shape, the air guides with relatively longer lengths may include both straight and curved shapes. Among the air guides 195A and 196A with the curved shape, the air guides disposed at the upper side may include both straight and curved shapes. Within the air guides 195A and 196A, the straight shapes may be arranged in a region adjacent to the window.

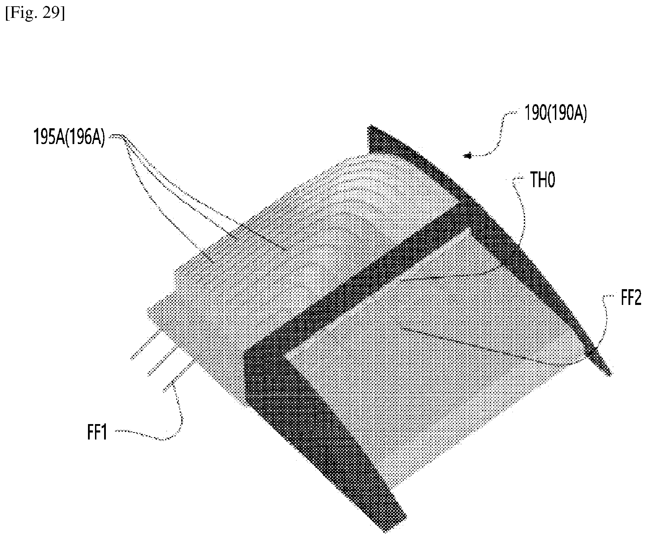

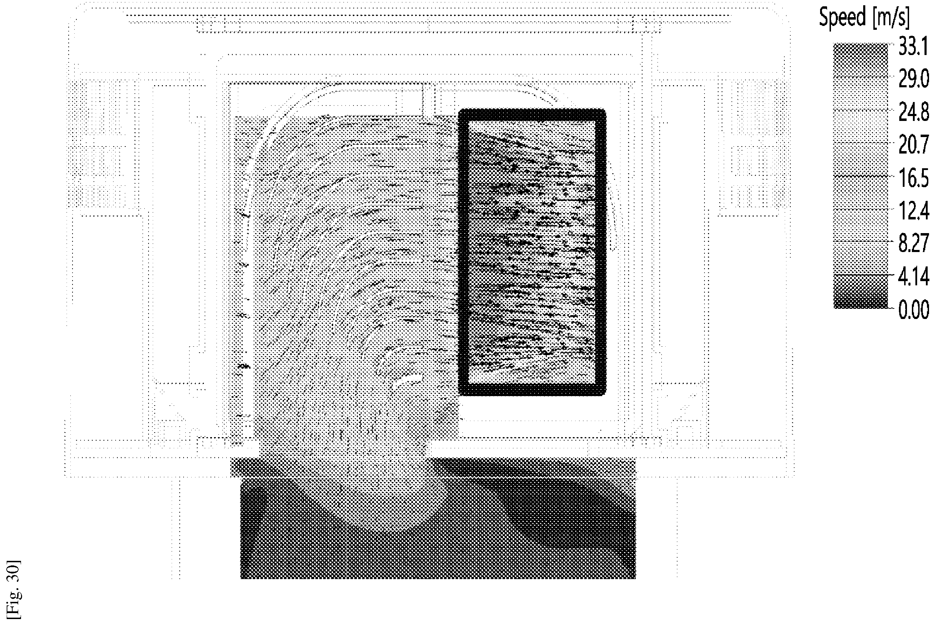

One end of the plurality of air guides 195A and 196A may be arranged horizontally at different heights in the region adjacent to the windows 191 and 192, guiding the flow of air introduced through a rotational direction or a lower second flow groove FH2. For example, the other ends of the plurality of air guides 195A and 196A may guide the incoming air toward the bottom frame 260. Conversely, as shown in FIGS. 29 and 30, when external air is introduced through the second flow groove FH2 of the lower side, the air guides 195A, 196A may guide the air introduced through the lower portion, dissipate the heat generated from internal heat-generating components (e.g., 26A and 36A, and guide to the windows 191 and 192 disposed on one surface of the air guides 195A and 196A.

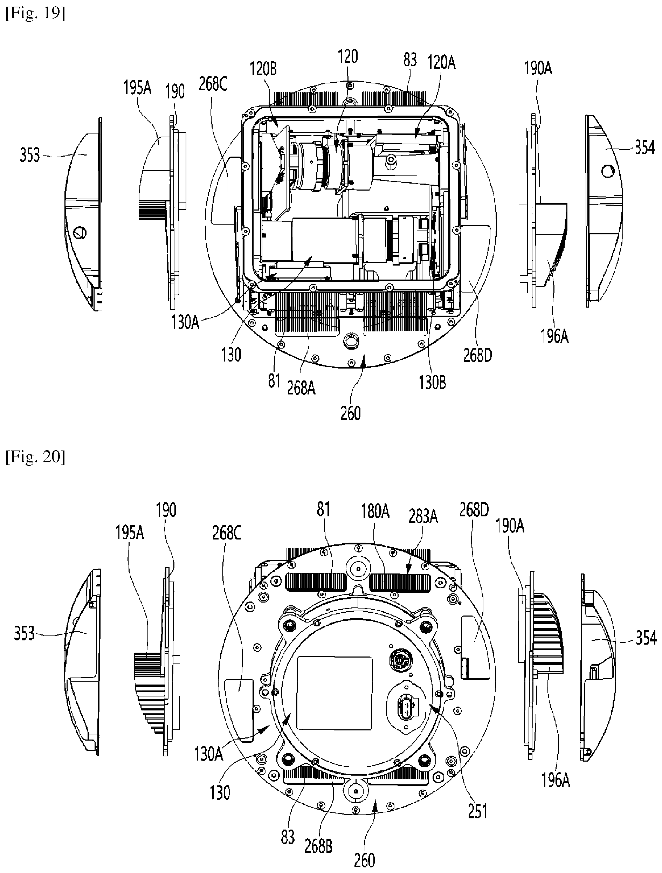

As shown in FIG. 19, the interior of the main frame 170 may include a plurality of heat-generating parts 120A, 120B, 130A, and 130B having heat-generating components such as the light source arrays, circuit boards, sensor arrays, etc. Heat dissipation members 81, 83, 195, and 196 may be disposed on the outer sides of each heat-generating part 120A, 120B, 130A, and 130B to improve heat dissipation efficiency.

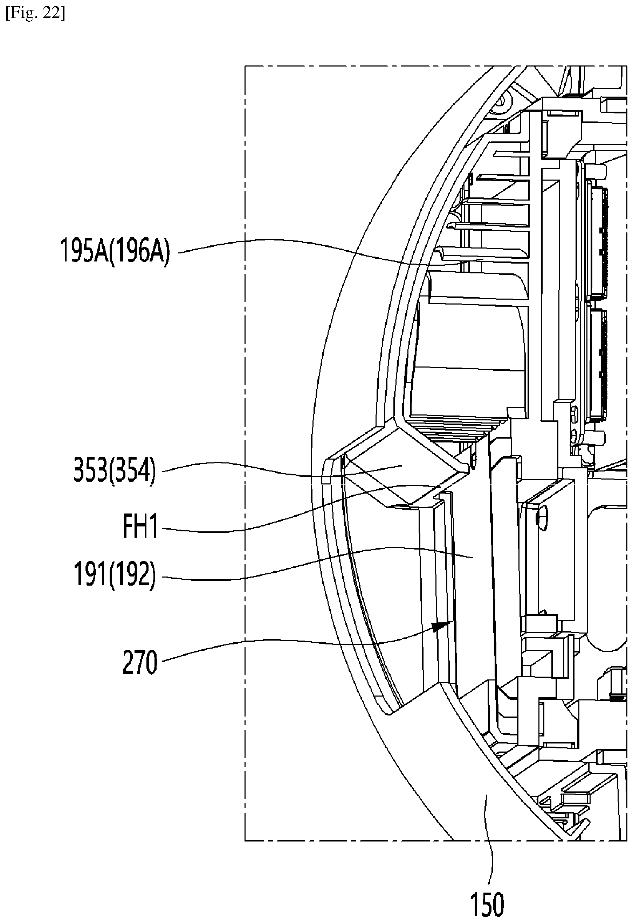

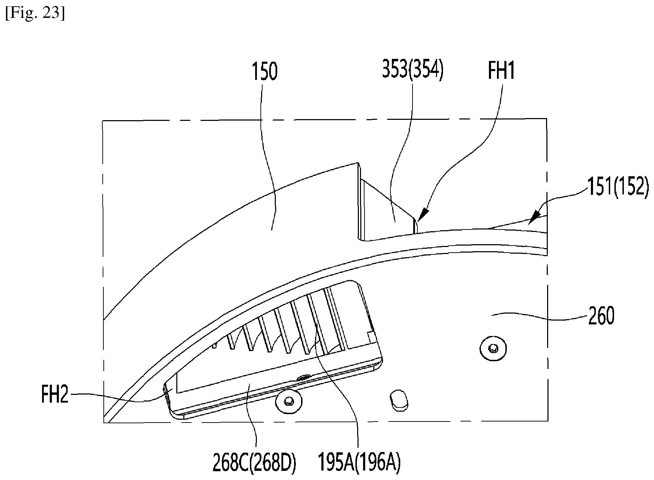

As shown in FIGS. 19 to 24, the bottom frame 260 may include heat dissipation holes 268C, 268D corresponding to the lower portion of the third and fourth heat dissipation members 195 and 196. That is, one end of each of the air guides 195A and 196A may be arranged parallel to each other with respect to the rotation direction of the rotating head. The other end of each of the air guides 195A and 196A may face the heat dissipation holes 268C, 268D of the bottom frame 260.

The third and fourth heat dissipation covers 353 and 354 may include a first flow groove FH1 on the inner side and a second flow groove FH2 on the lower portion. The first flow groove FH1 may be connected to the window holes 270 and may correspond to one end of the plurality of air guides 195A and 196A. The second flow groove FH2 may correspond to the heat dissipation holes 268C and 268D of the bottom frame 260 and the other end of the plurality of air guides 195A and 196A.

As shown in FIGS. 19, 20, and 25, the bottom frame 260 may include heat dissipation holes 268A and 268B corresponding to the lower portions of the first and second heat dissipation members 81 and 83. When each of the first and second heat dissipation members 81, 83 is arranged in a plurality of regions, each of the heat dissipation holes 268A and 268B at the lower portion may be arranged in plurality. The lower portions of the first and second frames 180 and 180A may be open, exposing the lower portions of the first and second heat dissipation members 81 and 83, and may be connected to the heat dissipation holes 268A and 268B. The upper outer sides of the first and second frames 180 and 180A may include an opening 189. The opening 189 may expose the upper portions of each of the first and second heat dissipation members 81 and 83.

In the cooling system or heat dissipation system of the LiDAR device, when a fan or flowing air is provided to the lower portion of the bottom frame 260, the incoming air may flow between the heat dissipation fins and between the air guides through each of the heat dissipation holes 268A, 268B, 268C, and 268D, and may be discharged toward the outer sides of the windows 191 and 192 through the first flow groove FH1 or may be discharged through the openings 189.

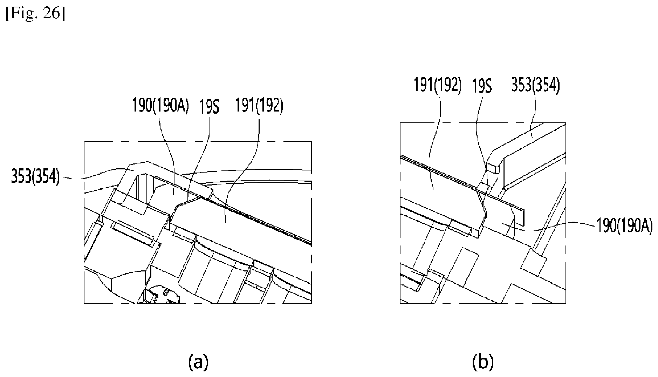

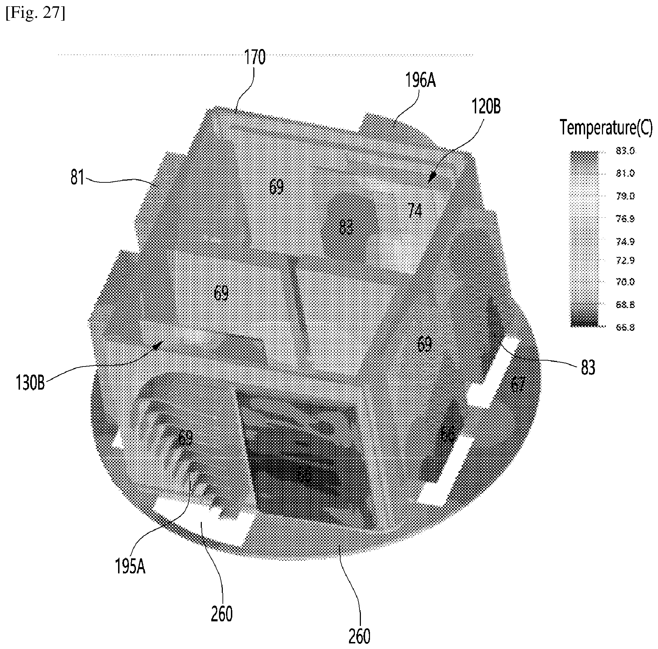

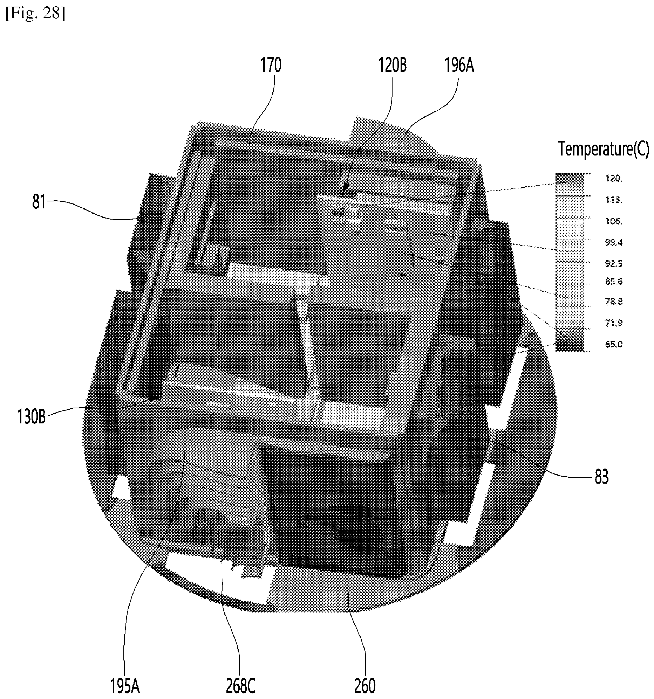

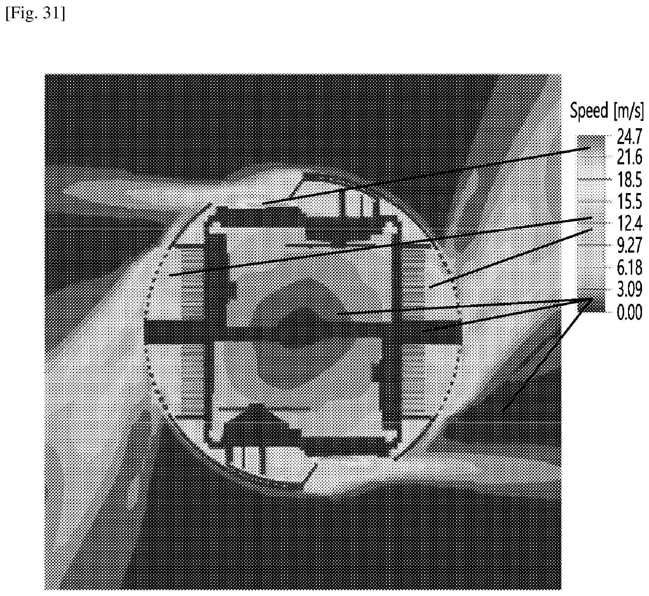

FIGS. 26 and 27 are views illustrating the heat distribution according to the operation of heat-generating components in the LiDAR device of the present invention, where the numbers 67, 69, 74, and 83 shown in each configuration indicate temperature, and it may be seen that a higher-than-reference heat is generated in the regions of the heat-generating parts 120B and 130B disposed inside the air guides 195A and 196A. As shown in FIGS. 28 to 30, when external incoming air FF1 is supplied to the air guides 195A and 196A according to an embodiment of the present invention through fans or the movement of a movable body, the incoming air FF1 may travel along the air guides 195A and 196A and may be discharged as exhaust air FF2 through the opposite end TH0. At this time, since the exhaust air FF2 is discharged toward the windows, changes due to heat at the windows 191 and 192 may be suppressed. Additionally, as shown in FIG. 31, uniform heat dissipation effects may be provided across the entire area by the heat dissipation members and the heat dissipation holes in the bottom frame.

The features, structures, and effects described in the above embodiments are included in at least one embodiment of the present invention and are not necessarily limited to a single embodiment. Furthermore, the features, structures, and effects illustrated in each embodiment may be combined or modified in other embodiments by those skilled in the art to which the embodiments pertain. Accordingly, such combinations and modifications should be interpreted as falling within the scope of the present invention. Additionally, while the above description has been provided with a focus on embodiments, it is merely an example and does not limit the present invention. Those skilled in the art to which the present invention pertains will understand that various modifications and applications not exemplified above are possible without departing from the essential characteristics of the embodiments. For example, each component specifically presented in the embodiments may be implemented in a modified form. Also, any differences related to such modifications and applications should be interpreted as being within the scope of the present invention as defined by the appended claims.

## Claims

1. A LiDAR device comprising:
a main frame having an accommodation part therein;
a transceiver assembly disposed in the accommodation part and having a circuit board, a light source array, and a sensor array;
a bottom frame disposed below the main frame; and
a plurality of heat dissipation members disposed on side surfaces of the main frame, respectively,
wherein the plurality of heat dissipation members comprise a plurality of vertically arranged heat dissipation fins and a plurality of curved air guides.

2. The LiDAR device of claim 1, wherein the bottom frame has heat dissipation holes that face lower portions of the plurality of heat dissipation members, respectively.

3. The LiDAR device of claim 2, further comprising a heat dissipation cover disposed at the outside of the plurality of heat dissipation members.

4. The LiDAR device of claim 3, wherein the heat dissipation cover comprises grooves at a lower portion thereof, which are connected to the heat dissipation holes of the bottom frame.

5. The LiDAR device of any one of claims 1 to 4, further comprising a plurality of frames coupled to the side surfaces of the main frame, respectively, and having the heat dissipation members,
wherein at least one of the plurality of frames comprises a window through which a laser beam is transmitted and received via the light source array and the sensor array, and
one of the plurality of heat dissipation members is disposed on one side of the window.

6. The LiDAR device of any one of claims 1 to 4, wherein the transceivers comprise: a first transceiver configured to emit and sense laser beams in a first direction; and a second transceiver configured to emit and sense laser beams in a direction opposite to the first direction,
the LiDAR device further comprises an upper cover or a cover frame disposed on the first and second transceivers and coupled to an upper inner perimeter of the main frame, and
the bottom frame is coupled to a lower inner perimeter of the main frame.

7. The LiDAR device of claim 6, further comprising a first window disposed at a beam incidence side of the first transceiver and a second window disposed at a beam incidence side of the second transceiver,
wherein the first and second windows are disposed outward with respect to the main frame.

8. The LiDAR device of claim 7, wherein the first transceiver comprises a first receiving optical system and a first sensor array,
the second transceiver comprises a second receiving optical system and a second sensor array, and
the LiDAR device further comprises a first lens tube disposed between the first receiving optical system and the first window and a second lens tube disposed between the second receiving optical system and the second window.

9. The LiDAR device of claim 8, further comprising a housing that covers an upper portion and an outer side of the main frame,
wherein the housing has window holes through which laser beams are transmitted and received.

10. The LiDAR device of any one of claims 1 to 4, further comprising:
a fixed frame that is secured to a movable body and has a stator; and
a rotating frame that has a rotor facing the stator and is configured to rotate axially on the fixed frame,
wherein the rotating frame rotates together with the main frame, the bottom frame, and the transceivers.

11. The LiDAR device of any one of claims 1 to 4, wherein the plurality of heat dissipation fins and the plurality of air guides have flow paths for inflow and outflow of external air.
